# EUROPEAN PATENT SPECIFICATION

(11) **EP 0 359 567 B1**
(45) Date of publication and mention of the grant of the patent: **17.08.1994**
(21) Application number: 89309352.6
(22) Date of filing: 14.09.1989
(51) Int. Cl.: C23C 16/50, C23C 16/26

(54) **Plasma processing method and apparatus**
Verfahren und Vorrichtung zur Plasmabehandlung
Méthode et appareillage de traitement par plasma

(30) Priority: 16.09.1988 JP 233166/88; 16.09.1988 JP 233167/88; 16.09.1988 JP 233168/88
(43) Date of publication of application: 21.03.1990
(73) Proprietor: SEMICONDUCTOR ENERGY LABORATORY CO., LTD., Atsugi-shi Kanagawa-ken, 243 (JP)
(72) Inventor: Yamazaki, Shunpei, Tokyo, 157 (JP); Tsuchiya, Mitsunori, Atsugi-shi Kanagawa-ken, 243 (JP); Hayashi, Shigenori, Atsugi-shi Kanagawa-ken, 243 (JP); Hirose, Naoki, Atsugi-shi Kanagawa-ken, 243 (JP); Ishida, Noriya, Atsugi-shi Kanagawa-ken, 243 (JP); Sasaki, Mari, Atsugi-shi Kanagawa-ken, 243 (JP); Kawano, Atsushi, Isehara-shi Kanagawa-ken, 259-11 (JP)
(74) Representative: Milhench, Howard Leslie

(56) References cited:
- EP-A- 0 304 220
- EP-A- 0 327 406
- EP-A- 0 361 206
- EP-A- 0 372 696
- US-A- 4 464 223
- US-A- 4 723 508

## Description

### FIELD OF THE INVENTION

The present invention relates to an improved plasma processing method and apparatus. More particularly, but not exclusively, it relates to a method of adhering a protective film of carbonaceous material to comparatively soft substrates in order to provide a transparent electrically insulating coating thereon.

### BACKGROUND OF THE INVENTION

Hard, thin films of diamond-like carbon have been deposited on substrates in a number of ways. By "diamond-like carbon" is meant carbon with exceptional hardness, e.g. which can neither be cut with a razor blade nor scratched by rubbing with steel wool. The chemical bonding of such diamond-like carbon appears to be dominated by sp³ tetrahedral diamond-like bonding as opposed to the sp² triagonal bonding of graphite. Diamond-like carbon films may or may not give evidence of crystallinity by x-rays.

JP-A-56-146936 describes a process in which carbon deposition is carried out with the deposited carbon material being subjected to attack by accelerated ions at the same time so that soft portions of the deposited material are selectively removed to leave comparatively hard material. This technique is excellent for increasing the hardness of the carbon film thus deposited. Substrates to be coated in accordance with this technique, however, have to be given bias voltages in order to cause sputtering action thereon. For this reason, the advantage of this technique is diminished when the substrates are made of insulating materials.

EP-A-0327406 (forming part of the state of the art only under Article 54(3)) discloses a process for carbon deposition in a plasma process under vacuum in which there are provided a vacuum chamber, a vacuum pump, a gas introduction system for introducing a reactive gas into the chamber, a pair of electrodes in the vacuum chamber and a high frequency source for applying an A/C voltage across the electrodes to convert the reactive gas into a plasma. The substrates to be coated are held in a substrate holder which is electrically connected to a lower frequency A/C source.

### OBJECTS AND SUMMARY OF THE INVENTION

It is therefore an object of the present invention to provide a plasma processing apparatus and method which enables the above problems of the prior art to be overcome.

Another object of the present invention is to provide a plasma processing method and apparatus which enables diamond-like carbonaceous films to be deposited onto substrates formed of electrically insulating materials.

The above and other objects of the present invention may be accomplished by use of a plasma processing method and apparatus wherein ion bombardment of a substrate by ions of the plasma is achieved by provision of supplementary electrodes within the plasma region and application to said supplementary electrodes of a voltage such as to cause plasma ions to impact the substrate.

More particularly, the present invention provides a plasma processing apparatus comprising:
a vacuum chamber;
a vacuum pump connected to said vacuum chamber in order to evacuate said chamber;
a gas introduction system connected to said vacuum chamber in order to input a reactive gas into said chamber;
a pair of first electrodes provided in said vacuum chamber;
a first voltage source for applying a first alternating voltage at a high frequency between said first electrodes in order to convert the reactive gas in said vacuum chamber into a plasma; and
a substrate holder for supporting a substrate to be treated by said apparatus between said first electrodes; characterised by
a pair of second electrodes arranged in order that the substrate supported by said holder is located between said second electrodes; and
a second voltage source for applying a second alternating voltage between said second electrodes, the frequency of said second alternating voltage being so low as to enable said plasma to follow it.

Thus in accordance with an exemplary embodiment of the invention, a pair of auxiliary electrodes are provided in a vacuum chamber on opposite sides of a substrate to be treated, in addition to other electrodes that are provided for producing plasma gas in the vacuum chamber. As compared to the high frequency voltage that is used for forming the plasma, a relatively low frequency voltage is applied between the auxiliary electrodes in order to cause the bombardment of ions of plasma upon the substrate.

The invention also extends to a method of treating a substrate by plasma processing in a vacuum chamber comprising:
disposing said substrate between a pair of first electrodes in said vacuum chamber;
inputting a reactive gas into said vacuum chamber at an appropriate pressure; and
inputting a first alternating voltage between said first electrodes at a high frequency in order to produce a plasma from said reactive gas and to perform plasma processing of said substrate;
characterised in that a second alternating voltage is applied between a pair of second electrodes located to sandwich said substrate, said second alternating voltage being at a frequency at which said plasma can follow said second voltage.

By virtue of such plasma treatment in accordance with the present invention, hard films can be deposited since the bombardment of the forming coating with plasma ions tends to selectively remove soft portions of the material that is deposited during the deposition process. When carbonaceous films are formed by use of a plasma comprising a carbon compound gas, the hardness and the resistivity of the films can be controlled by adding a fluorine compound gas. The fluorine contained in the carbon film that is deposited functions also to enhance the water repellent property of the film. Such carbon films are suitable for protective coatings on glass windows of vehicles, for example.

Other substrates suitable for treatment in accordance with the teachings of the present invention are made of, for example, insulating materials having resistivities not lower than 10¹⁵ ohm centimeters, such as polyesters, alkyd resins, oil-free alkyd resins, unsaturated polyesters, acrylic resins and amino-resins. Particularly, suitable organic material used in manufacture of motorcars are acrylic lacquers, acrylic melanins and block acrylic urethanes.

Further features of the invention are set forth in the appended claims and, together with the above features, can be better understood from consideration of the following detailed description of exemplary embodiments when read in conjunction with the acompanying drawings.

### BRIEF DESCRIPTION OF THE DRAWINGS

Fig.1 is a schematic cross sectional diagram showing a plasma CVD apparatus in accordance with one embodiment of the present invention;
Figs.2(A) and 2(B) are vertical and horizontal cross sectional views showing a window glass for motor cars which has been coated with a carbon protective film in accordance with the present invention;
Fig.2(C) is a schematic cross sectional view showing a modification of the embodiment shown in Figs.2(A) and 2(B);
Figs.3(A) and 3(B) are horizontal and perspective cross sectional views showing a cylinder coated with a carbon protective film in accordance with the present invention;
Figs.4(A) and 4(B) are perspective and cross sectional views showing a rule coated with a carbon protective film in accordance with the present invention; and
Figs.5(A) and 5(B) are perspective and cross sectional views showing a set square coated with a carbon protective film in accordance with the present invention.

### DETAILED DESCRIPTION OF THE EMBODIMENTS

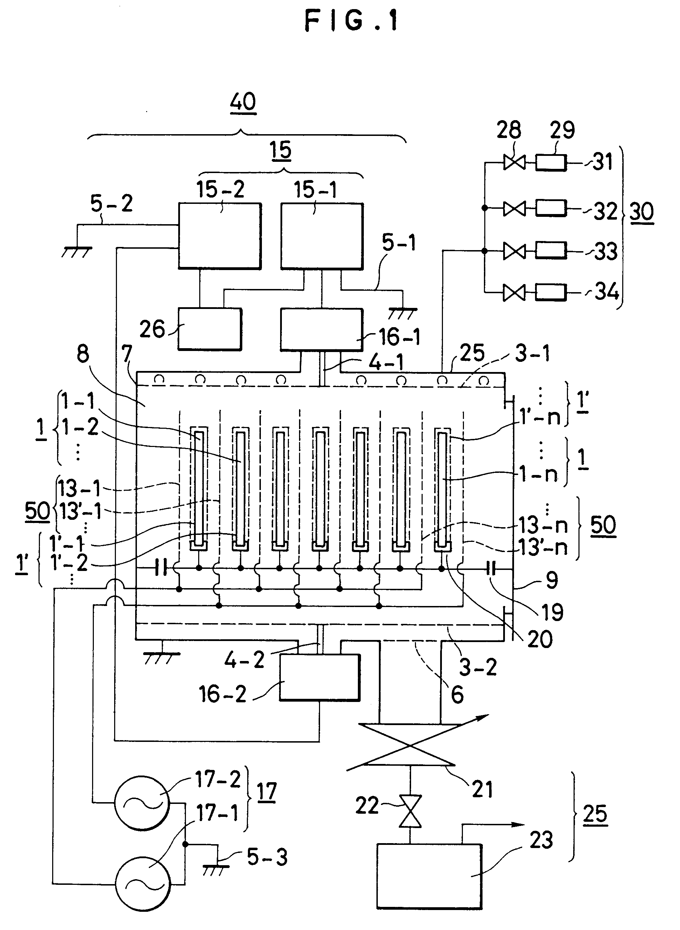

Referring now to Fig.1, a chemical vapor deposition apparatus is illustrated. The apparatus comprises a vacuum chamber 9 defining a deposition space therein, an evacuation system 25 comprising a rotary pump 23 and a turbo-molecular pump 22 which are connected to the chamber 7 through a valve 21, a gas supply system 30 comprising four gas supply lines, each being provided with a flow meter 29 and a valve 28, connected to the reaction chamber 7, a pair of mesh electrodes 3-1 and 3-2 made of aluminum and located at upper and lower positions inside of the deposition space, a power supply 40 for supplying energy to the mesh electrodes 3-1 and 3-2, a plurality of substrate holders 20 for holding substrates 1, the holders 20 being connected to the chamber 7 through capacitors 19, a plurality of Al mesh electrodes 50 (13-n, 13′-n) interposed between adjacent substrates and outside of the first and last substrates, and a bias voltage applying means 17 for applying an AC voltage between adjacent ones of the electrodes 50. The reaction chamber 7 is provided with a gate valve 9 through which substrates to be coated may be disposed in the chamber.

The energy supply 40 comprises a first power source 15-1 which supplies an AC voltage to the mesh electrode 3-1 through a matching device 16-1 comprising a LCR circuit, a second power source 15-2 which supplies an AC voltage to the mesh electrode 3-2 through a matching device 16-2 comprising a LCR circuit, and a phase adjuster 26 connected between the first and second power sources 15-1 and 15-2. Both the first and second power sources are grounded at terminals 5-1 and 5-2. The bias applying device 17 is provided with first and second AC voltage sources 17-1 and 17-2, which supply AC voltages between adjacent electrodes 13-n and 13-n'. One terminal of each of the voltage sources 17-1 and 17-2 is grounded at 5-3.

In operation, after evacuating the chamber 7, a carbon compound gas is introduced into the deposition space 8 at a pressure of from 0.133 to 133 Pa (0.001 to 1 Torr). For example, the carbon compound gas may consist of C₂F₆ and C₂H₄ in the ratio of from 1:4 to 4:1, e.g. 1:1, and may be introduced so that the pressure in the reaction chamber 7 becomes 67 Pa (0.5 Torr). The transparency and resistivity of the carbon material that is deposited can be controlled by changing the amount of fluorine contained in the carbon material through adjustment of the introduction rate of C₂F₆ relative to C₂H₄. The temperature in the deposition space is no higher than 150°C. High frequency alternating voltages of from 1 MHz to 100 MHz, e.g. 13.56 MHz, are applied to the mesh electrodes 3-1 and 3-2 from the first and second power sources 15-1 and 15-2. The phase difference between these high frequency voltages is adjusted to be O° or 180° by means of the phase adjuster 26. By virtue of the injections of such high frequency energy into the plasma chamber, the carbon compound gas is converted into a plasma state and carbon deposition onto the substrates occurs. The deposition rate is from 10nm to 100nm/min (100 to 1000 A°/min). The thickness of the deposited carbon films may be from 0.1 to 8mm on flat surfaces and from 1 to 3mm on uneven surfaces.

At the same time, an AC voltage is applied between adjacent electrodes 13-n and 13'-n in order to induce an electric field normal to the major surfaces of each substrate. The frequency of the AC voltage between the electrodes 13-n and 13'-n is selected to be in the range of from 10 Hz to 100 KHz, e.g., 50 Hz. At such comparatively low frequencies, plasma ions can follow the electric field and bombard the substrate surfaces on which carbon deposition is being carried out. As a result, softer deposited materials are removed so that the hardness of the carbon material that remains is relatively high, e.g. 600 to 6000 kg/mm². The resistivity of the carbon is, for example, from 1 x 10⁶ to 5 x 10¹² ohm centimeter, typically from 1 x 10⁷ to 1 x 10¹¹ ohm centimeter. The optical energy band gap is no narrower than 1.0 eV, typically 1.5 to 5.5 eV. The carbon material may include hydrogen at 30 atom% or less and fluorine at 0.3 to 10 atom%.

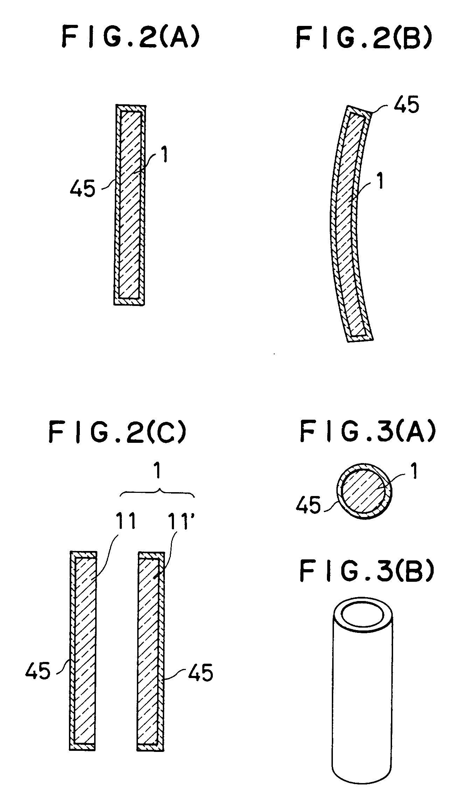

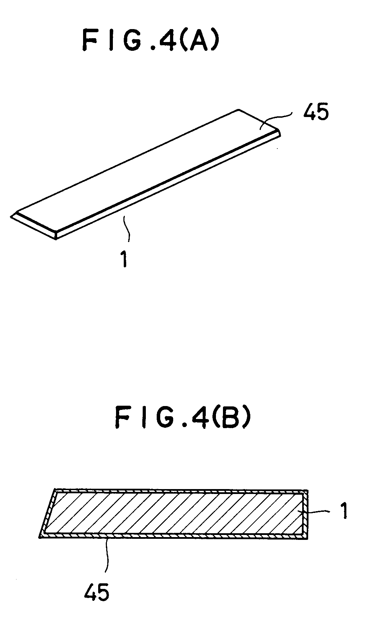

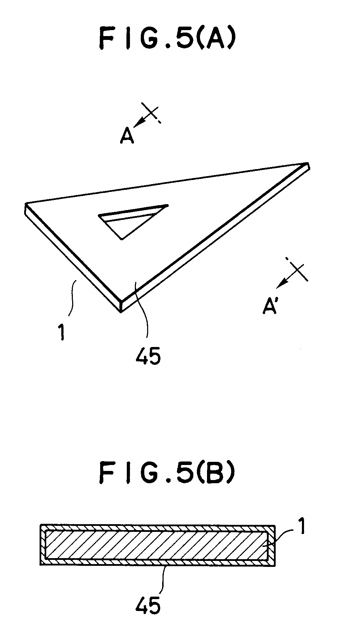

Carbonaceous films were coated on several substrates in accordance with the present invention. Figs.2(A) and 2(B) are horizontal and vertical cross sectional views showing a curved glass or plastic pane 1 to be fitted in the front window of a motor car, the pane 1 being coated with a carbonaceous film 45 of from 0.1 to 8mm thickness. The whole surface of the glass pane 1 may be coated with carbon film in accordance with the present invention, or alternatively only one side of the pane may be coated. In the latter case, panes treated in the apparatus shown in Fig. 1 may be disposed in parallel with each other in order to make pairs as illustrated in Fig.2(C). Figs. 3(A) and 3(B) illustrate a similar carbon coating formed on a cylindrical substrate. Figs.4(A) and 4(B) illustrate a similar carbon coating formed on a plastic rule 1. Figs. 5(A) and 5(B) illustrate a 0.5mm carbon coating formed on a set square.

While several embodiments have been specifically described by way of example, it is to be appreciated that the present invention is not limited to the particular examples described and that modifications and variations can be made. For example, the present invention is useful when front, side or rear windows or side mirrors are coated with carbon protective films.

## Claims

1. A plasma processing apparatus comprising:
a vacuum chamber (9);
a vacuum pump (25) connected to said vacuum chamber in order to evacuate said chamber;
a gas introduction system (30) connected to said vacuum chamber in order to input a reactive gas into said chamber;
a pair of first electrodes (3-1, 3-2) provided in said vacuum chamber;
a first voltage source (40) for applying a first alternating voltage at a high frequency between said first electrodes in order to convert the reactive gas in said vacuum chamber into a plasma; and
a substrate holder (20) for supporting a substrate to be treated by said apparatus between said first electrodes; characterised by
a pair of second electrodes (13-n, 13'-n) arranged in order that the substrate supported by said holder (20) is located between said second electrodes; and
a second voltage source (17) for applying a second alternating voltage between said second electrodes, the frequency of said second alternating voltage being so low as to enable said plasma to follow it.

2. The apparatus of claim 1 wherein the frequency of said first alternating voltage is selected to be in the range of 1 MHz to 50 MHz.

3. The apparatus of claim 2 wherein the frequency of said second alternating voltage is selected to be in the range of 10 Hz to 100 KHz.

4. The apparatus of any of claims 1 to 3 wherein said substrate holder (20) is adapted to support a plurality of substrates arranged in parallel with each other.

5. The apparatus of claim 4 wherein said second electrodes (13-n, 13'-n) are located between adjacent ones of said substrates.

6. A method of treating a substrate by plasma processing in a vacuum chamber (9) comprising:
disposing said substrate between a pair of first electrodes (3-1, 3-2) in said vacuum chamber (9);
inputting a reactive gas into said vacuum chamber (9) at an appropriate pressure; and
inputting a first alternating voltage between said first electrodes (3-1, 3-2) at a high frequency in order to produce a plasma from said reactive gas and to perform plasma processing of said substrate;
characterised in that a second alternating voltage is applied between a pair of second electrodes (13-n, 13'-n) located to sandwich said substrate, said second alternating voltage being at a frequency at which said plasma can follow said second voltage.

7. The method of claim 6 wherein said substrate is made from an insulating material.

8. The method of claim 6 or 7 wherein said reactive gas is decomposed in order to deposit a film on said substrate.

9. The method of claim 6 or 7 or 8 wherein said reactive gas is a carbon compound gas.

10. The method of any of claims 6 to 9 wherein said film comprises diamond-like carbon.

11. A plasma CVD method utilizing a vacuum chamber (9) having two sets of electrodes (3-1, 3-2, 13-n, 13'-n), and wherein a high frequency voltage is applied between one set of electrodes (3-1, 3-2) in order to produce a plasma from a reactive gas introduced into the chamber (9), a substrate to be coated is operatively located relative to and spaced from the other set of electrodes (13-n, 13'-n), and a relatively low frequency voltage is applied to the other set of electrodes (13-n, 13'-n) for effecting bombardment of the substrate surface with plasma ions whereby relatively soft parts of the coating being deposited will be removed leaving only harder material.

## Patentansprüche

1. Plasmabehandlungsvorrichtung mit:
- einer Vakuumkammer (9);
- einer Vakuumpumpe (25), die mit der Vakuumkammer verbunden ist, um die Kammer zu evakuieren;
- einem Gaseinlaßsystem (30), das mit der Vakuumkammer verbunden ist, um ein Reaktionsgas in die Kammer einzuleiten;
- einem Paar erster Elektroden (3-1, 3-2), die in der Vakuumkammer angeordnet sind;
- einer ersten Spannungsquelle (40) zum Anlegen einer ersten Wechselspannung hoher Frequenz an die ersten Elektroden, um das Reaktionsgas in der Vakuumkammer in ein Plasma umzusetzen; und
- einem Substrathalter (20) zum Halten eines von der Vorrichtung zu behandelnden Substrats Zwischen den ersten Elektroden;
**gekennzeichnet durch**
- ein Paar zweiter Elektroden (13-n, 13'-n), die so angeordnet sind, daß das vom Halter (20) gehaltene Substrat zwischen den zweiten Elektroden liegt; und
- eine zweite Spannungsquelle (17) zum Anlegen einer zweiten Wechselspannung an die zweiten Elektroden, wobei die Frequenz der zweiten Wechselspannung so niedrig ist, daß das Plasma ihr folgen kann.

2. Vorrichtung nach Anspruch 1, bei der die Frequenz der ersten Wechselspannung so ausgewählt ist, daß sie im Bereich von 1 MHz bis 50 MHz liegt.

3. Vorrichtung nach Anspruch 2, bei der die Frequenz der zweiten Wechselspannung so ausgewählt ist, daß sie im Bereich von 10 Hz bis 100 kHz liegt.

4. Vorrichtung nach einem der Ansprüche 1 bis 3, bei der der Substrathalter (20) so ausgebildet ist, daß er mehrere parallel zueinander angeordnete Substrate hält.

5. Vorrichtung nach Anspruch 4, bei der die beiden Elektroden (13-n, 13'-n) zwischen benachbarten Substraten angeordnet sind.

6. Verfahren zum Behandeln eines Substrats durch Plasmabehandlung in einer Vakuumkammer (9), umfassend:
- Anordnen des Substrats zwischen einem Paar erster Elektroden (3-1, 3-2) in der Vakuumkammer (9);
- Einleiten eines Reaktionsgases mit geeignetem Druck in die Vakuumkammer (9); und
- Anlegen einer ersten Wechselspannung hoher Frequenz an die ersten Elektroden (3-1, 3-2), um aus dem Reaktionsgas ein Plasma zu erzeugen, und um eine Plasmabehandlung des Substrats vorzunehmen;
**dadurch gekennzeichnet, daß** eine zweite Wechselspannung an ein Paar zweiter Elektroden (13-n, 13'-n) angelegt wird, die so angeordnet sind, daß sie das Substrat zwischen sich einschließen, wobei die zweite Wechselspannung eine Frequenz aufweist, bei der das Plasma der zweiten Spannung folgen kann.

7. Verfahren nach Anspruch 6, bei dem das Substrat aus einem isolierenden Material besteht.

8. Verfahren nach einem der Ansprüche 6 oder 7, bei dem das Reaktionsgas zersetzt wird, um einen Film auf dem Substrat abzuscheiden.

9. Verfahren nach einem der Ansprüche 6 oder 7 oder 8, bei dem das Reaktionsgas ein Gas einer Kohlenstoffverbindung ist.

10. Verfahren nach einem der Ansprüche 6 bis 9, bei dem der Film diamantähnlichen Kohlenstoff aufweist.

11. Plasma-CVD-Verfahren unter Verwendung einer Vakuumkammer (9) mit zwei Sätzen von Elektroden (3-1, 3-2, 13-n, 13'-n), bei dem eine hochfrequente Spannung an einen Satz Elektroden (3-1, 3-2) angelegt wird, um aus einem in die Kammer (9) eingeleiteten Reaktionsgas ein Plasma zu erzeugen, wobei ein zu beschichtendes Substrat funktionsmäßig in bezug auf den anderen Satz Elektroden (13-n, 13'-n) und beabstandet von diesem angeordnet ist, und eine Spannung relativ niedriger Frequenz an den anderen Satz Elektroden (13-n, 13'-n) angelegt wird, um einen Beschuß der Substratoberfläche mit Plasmaionen hervorzurufen, wodurch relativ weiche Teile der abgeschiedenen Beschichtung entfernt werden, was nur härteres Material zurückläßt.

## Revendications

1. Appareil de traitement au plasma comprenant :
une chambre à vide (9) ;
une pompe à vide (25) raccordée à ladite chambre à vide pour faire le vide dans cette chambre ;
un système (30) d'introduction de gaz raccordé à ladite chambre à vide pour introduire un gaz réactif dans ladite chambre ;
une paire de premières électrodes (3-1, 3-2) prévues dans ladite chambre à vide ;
une première source de tension (40) servant à appliquer une première tension alternative à une haute fréquence entre lesdites premières électrodes pour transformer le gaz réactif contenu dans ladite chambre à vide en un plasma ; et
un support de substrat (20) servant à supporter un substrat qui doit être traité par ledit appareil entre lesdites premières électrodes ; caractérisé par
une paire de deuxièmes électrodes (13-n, 13'-n) agencées de manière que le substrat supporté par ledit support (20) soit placé entre lesdites deuxièmes électrodes ; et
une deuxième source de tension (17) servant à appliquer une deuxième tension alternative entre lesdites deuxièmes électrodes, la fréquence de ladite tension alternative étant suffisamment basse pour permettre audit plasma de la suivre.

2. Appareil selon la revendication 1, dans lequel la fréquence de ladite première tension alternative est choisie pour être dans l'intervalle de 1 MHz à 50 MHz.

3. Appareil selon la revendication 2, dans lequel la fréquence de ladite deuxième tension alternative est choisie pour être dans l'intervalle de 10 Hz à 100 kHz.

4. Appareil selon une quelconque des revendications 1 à 3, dans lequel ledit support de substrat (20) est adapté pour supporter une pluralité de substrats disposés parallèlement entre eux.

5. Appareil selon la revendication 4, dans lequel lesdites deuxièmes électrodes (13-n, 13'-n) sont placées entre des substrats adjacents.

6. Procédé pour traiter un substrat par traitement au plasma dans une chambre à vide (9), comprenant les phases consistant à :
disposer ledit substrat entre les électrodes d'une paire de premières électrodes (3-1, 3-2) à l'intérieur de ladite chambre à vide (9) ;
introduire un gaz réactif dans ladite chambre à vide à une pression appropriée ; et
appliquer une première tension alternative entre lesdites premières électrodes (3-1, 3-2) à une haute fréquence pour produire un plasma à partir dudit gaz réactif, et pour effectuer le traitement au plasma dudit substrat ;
caractérisé en ce qu'on applique une deuxième tension alternative entre les électrodes d'une paire de deuxièmes électrodes (13-n, 13'-n) placées pour encadrer ledit substrat, ladite deuxième tension alternative étant d'une fréquence à laquelle ledit plasma peut suivre ladite deuxième tension.

7. Procédé selon la revendication 6, dans lequel ledit substrat est fait d'une matière isolante.

8. Procédé selon la revendication 6 ou 7, dans lequel ledit gaz réactif est décomposé pour déposer un film sur ledit substrat.

9. Procédé selon la revendication 6 ou 7 ou 8, dans lequel ledit gaz réactif est un gaz d'un composé de carbone.

10. Procédé selon une quelconque des revendications 6 à 9, dans lequel ledit film comprend du carbone du type diamant.

11. Procédé de déposition chimique en phase vapeur au plasma utilisant une chambre à vide (9) munie de deux jeux d'électrodes (3-1, 3-2, 13-n, 13'-n), et dans lequel une tension à haute fréquence est appliquée entre les électrodes d'un jeu d'électrodes (3-1, 3-2) pour produire un plasma à partir d'un gaz réactif introduit dans la chambre (9), et un substrat à revêtir est placé fonctionnellement dans une position relative par rapport aux électrodes de l'autre jeu d'électrodes (13-n, 13'-n) et espacé de cet autre jeu, et une tension relativement basse est appliquée à l'autre jeu d'électrodes (13-n, 13'-n) pour effectuer le bombardement de la surface du substrat avec des ions de plasma, de manière que les parties relativement molles du revêtement à déposer soient éliminées, en ne laissant subsister que la matière dure.
